Europäisches Patentamt

European Patent Office

Office européen des brevets

(11) Publication number: **0 416 877 A2**

# EUROPEAN PATENT APPLICATION

(21) Application number: 90309675.8

(22) Date of filing: 04.09.90

(51) Int. Cl.5: **G06F 1/12**

(30) Priority: 06.09.89 US 403412

(43) Date of publication of application:
13.03.91 Bulletin 91/11

(84) Designated Contracting States:
DE FR GB IT

(71) Applicant: **INTERNATIONAL CONTROL AUTOMATION FINANCE S.A.**
16 Rue des Bains
Ville de Luxembourg(LU)

(72) Inventor: **Mills, Jeff Steven**
5150A Community Drive
Willoughby Ohio 44094(US)
Inventor: **Thompson, William Lee**
15364 Gar Highway
Montville, Ohio 44064(US)

(74) Representative: **Cotter, Ivan John et al**
D. YOUNG & CO. 10 Staple Inn
London WC1V 7RD(GB)

(54) **Frequency synchronisation.**

(57) A synchronisation circuit (16; 40) synchronises the frequency of a frequency/pulse width control circuit (14) with the frequency of a switching power supply circuit (12) for a vortex shedding flowmeter. Synchronisation can be achieved by pre-triggering the frequency of the frequency/pulse width control circuit (14) with a signal provided by the switching power supply circuit (12). Alternatively, a down-counter approach can be utilised to achieve similar frequency synchronisation.

FIG. 1

# FREQUENCY SYNCHRONISATION

This invention relates to synchronising a frequency of a first circuit with a frequency of a second circuit.

Previous control circuits for vortex shedding flowmeters have utilised independent timing devices for a preamplifier sample and hold circuit and a switching power supply circuit. An inherent problem with the foregoing approach is that the higher frequency utilised by the switching power supply circuit can intermodulate with the sample and hold frequency of the pre-amplifier stage to produce a "beat" component having a frequency low enough to be within the passband of the system. This beat frequency component is very unstable with respect to variations in time and temperature and also varies from one device to another. In addition, the presence of this beat frequency component causes poor operation of the system. With respect to flowmeter applications, in cases of no flow, sufficient beat amplitudes may be present to cause false triggering. The regularity of this false triggering is sufficient to be interpreted as an actual flow condition. For low flow rates, when the signal amplitude is low, this relatively high amplitude beat component is sufficient to obscure the output signal so that accurate frequency measurements cannot be obtained. The result is an inaccurate frequency measurement for low flow, as well as no flow, conditions.

Because of the foregoing, it has become desirable to develop a circuit which eliminates or nullifies the beat frequency component resulting from using separate frequencies for the frequency/pulse width control circuit and the switching power supply circuit.

According to one aspect of the invention there is provided apparatus for synchronising a frequency of a first circuit with a frequency of a second circuit, the first circuit having a lower frequency than the frequency of the second circuit, the apparatus comprising:
differentiating means for differentiating a signal representative of the frequency of the second circuit to produce a differentiated signal;
coupling means for coupling the differentiated signal to the first circuit; and
means responsive to the differentiated signal to cause the first circuit to actuate in synchronisation with the second circuit.

According to another aspect of the invention there is provided apparatus for synchronising a frequency of a first circuit with a frequency of a second circuit, the first circuit having a lower frequency than the frequency of the second circuit, the apparatus comprising:

means for producing a signal having a frequency representative of the frequency of the second circuit;
counting means for counting discontinuities within said signal, the counting means being operative to produce an output signal having a frequency that is a division ratio of the frequency of the second circuit; and
means responsive to the output signal produced by the counting means to cause the first circuit to actuate in synchronisation with the second circuit.

A preferred (but not exclusive) application of the apparatus resides in synchronising the operation of circuitry associated with a flowmeter, and are particularly synchronising the frequency of a frequency/pulse width control circuit with a frequency of a switching power supply circuit for a vortex shedding flowmeter.

Preferred embodiments of the invention described hereinbelow solve or at least alleviate the problems associated with the prior art by synchronising the frequency of a frequency/pulse width control circuit with the frequency of a switching power supply circuit for a vortex shedding flowmeter. The foregoing is accomplished by making the lower frequency, that is the frequency associated with the frequency/pulse width control circuit, dependent on the higher frequency, that is the frequency associated with the switching power supply circuit. This frequency dependency can be achieved by pre-triggering the dependent frequency, that is the frequency of the frequency/pulse width control circuit, with a signal provided by the switching power supply circuit. Alternatively, a down-counter approach can be utilised to achieve frequency synchronisation, which results in the frequency of the frequency/pulse width control circuit being an exact and fixed division ratio of the frequency of the switching power supply circuit.

The invention will now be further described, by way of illustrative and non-limiting example, with reference to the accompanying drawings, in which:
Figure 1 is a schematic diagram of a synchronisation circuit in accordance with the invention in an application thereof in which it interconnects a switching power supply circuit and a frequency/pulse width control circuit;
Figure 2 is a schematic diagram of one embodiment of the synchronisation circuit illustrated in Figure 1; and
Figure 3 is a schematic diagram of another embodiment of the synchronisation circuit illustrated in Figure 1.

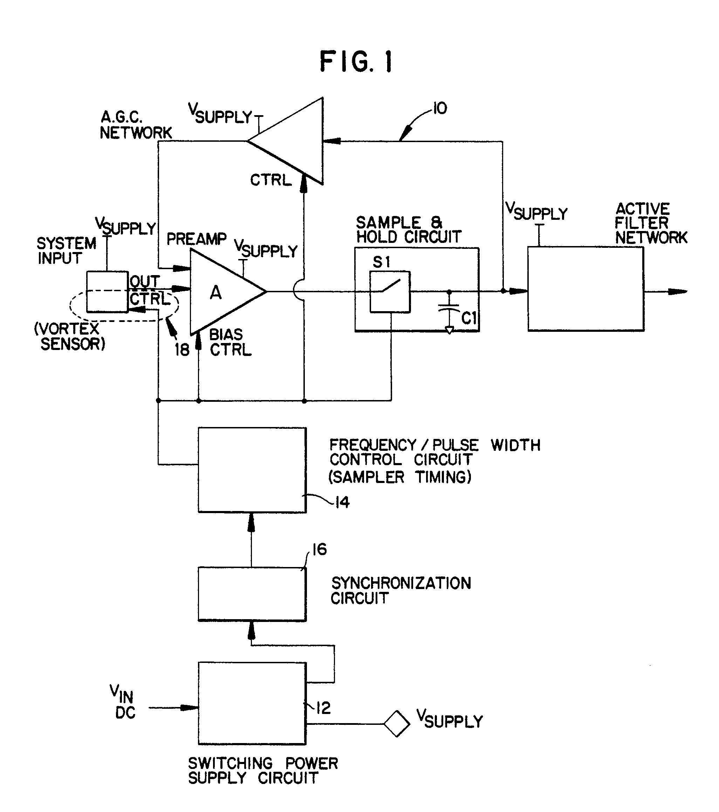

Figure 1 is a schematic diagram of a circuit 10 utilised in conjunction with a flowmeter, such as a vortex shedding flowmeter, and including a switching power supply circuit 12 which is utilised in conjunction with a frequency/pulse width control circuit 14 (timing circuit for a sample and hold circuit) to control the operation of a vortex shedding flowmeter (not shown). A synchronisation circuit 16 in accordance with the invention is used to synchronise the frequency of the frequency/pulse width control circuit 14 with the frequency of the switching power supply circuit 12. According to previous proposals, each of the circuits 12 and 14 had its own free running oscillator which was prone to drift and vary with temperature, time and component tolerance. With the arrangement of Figure 1, the lower frequency, that is the frequency associated with the frequency/pulse width control circuit 14, is dependent on the higher frequency, that is the frequency of the switching power supply circuit 12.

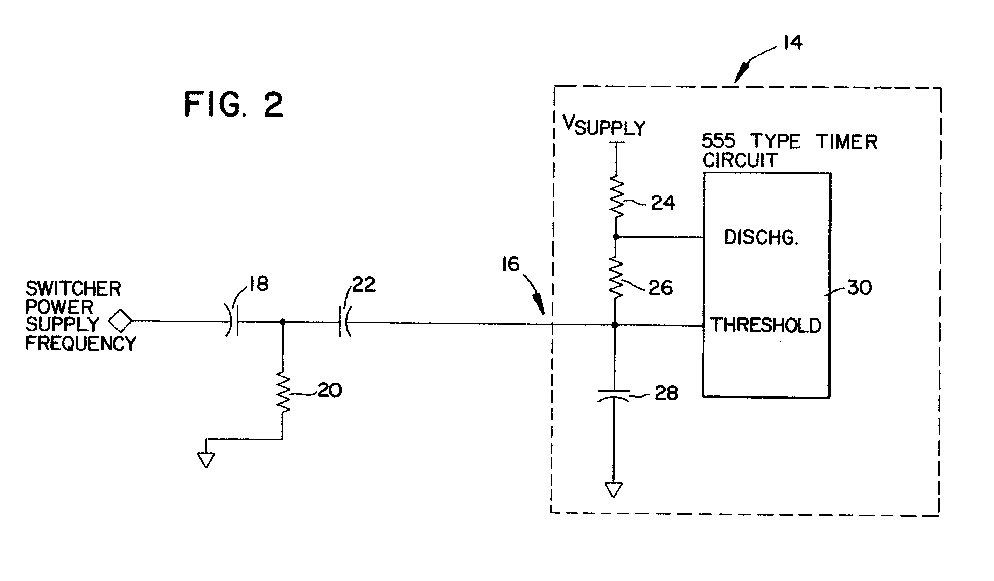

Figure 2 shows the synchronisation circuit 16 in detail. The synchronisation circuit 16 includes a capacitor 18 having one of its terminals connected to an output of the switching power supply circuit 12 and its other terminal connected to a resistor 20 which is also connected to a capacitor 22 and to earth (ground) potential. A series circuit comprising resistors 24, 26 and a capacitor 28 is connected between a supply voltage and earth potential. The capacitor 22 is connected to the junction of the resistor 26 and the capacitor 28, and to a threshold terminal of a timer circuit 30 associated with the frequency/pulse width control circuit 14. The junction between the resistors 24 and 26 is connected to a discharge terminal of the timer circuit 30. The timer circuit 30 is of the 555 type (typically an Intersil ICM 755) and establishes a frequency based on the values of the resistors 24, 26 and capacitor 28 and a duty cycle based on the values of the resistors 24 and 26.

The aforementioned frequency dependency is achieved by pre-triggering the dependent frequency, that is the frequency of the frequency/pulse width control circuit 14, with a signal derived from the higher frequency, that is the frequency of the switching power supply circuit 12. In order to accomplish the foregoing, a square wave output signal from a timer circuit associated with the switching power supply circuit 12 is differentiated by the capacitor 18 and resistor 20 to produce an approximately triangular waveform which is then capacitively coupled by the capacitor 22 to the capacitor 28 associated with the timer circuit 30. The timer circuit 30 produces a high output signal when the capacitor 28 is being charged through the resistors 24 and 26 and a low output signal when the capacitor 28 is discharging through the resistor 26. In this manner, a frequency and a duty cycle are established.

The output signal from the switching power supply circuit 12 is coupled to the foregoing charging and discharging waveform, resulting in "humps" being superimposed on its normally smooth resistive-capacitive wave shape. These "humps" correspond to the frequency of the switching power supply circuit 12 and cause the frequency/pulse width control circuit 14 to "pre-trigger", i.e. to trigger earlier than would normally occur with simple resistive-capacitive charging, thus causing the frequency of the frequency/pulse width control circuit 14 to come into synchronisation with the frequency of the switching power supply circuit 12.

The purpose of the differentiation stage comprising the capacitor 18 and resistor 20 is to provide positive synchronisation of the frequency of the frequency/pulse width control circuit 14 with the frequency of the switching power supply circuit 12. The capacitor 18 and resistor 20 produce a wave shape that has a steep face which then drops off, allowing the circuit 10 to "trigger" only on this steep face. A non-differentiated signal could trigger on the top as well as on the face of the signal.

By use of the foregoing synchronisation technique, the frequency of the frequency/pulse width control circuit 14 is dependent on the frequency of the switching power supply circuit 12. This dependency (synchronisation) causes any beat components, resulting from the two previously independent frequencies, to be nullified. The resulting synchronisation is stable over environmental changes and variations in component tolerances.

It has been proven experimentally that use of the foregoing synchronisation circuit 16 to make the frequency of the frequency/pulse width control circuit 14 dependent on the frequency of the switching power supply circuit 12 eliminates noise. The resulting circuit 10 can also detect very low flow rates resulting in a lowering of the minimum measurable flow rate specification of a vortex shedding flowmeter. The circuit 10 also eliminates any instabilities that had been experienced in no flow situations, i.e. flowmeters indicating flow rates when no flow existed.

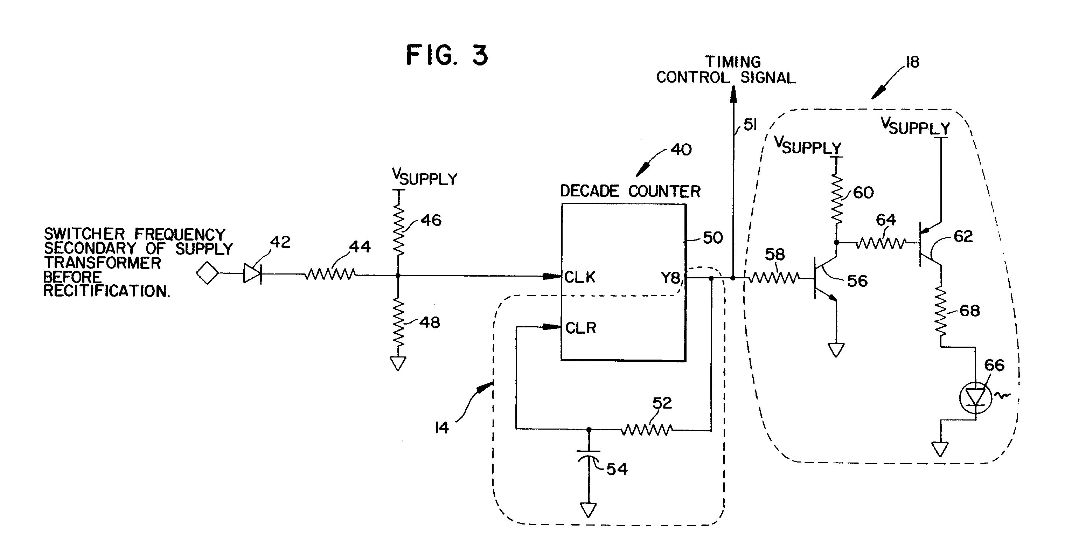

An alternative embodiment of the invention is illustrated in Figure 3, which is a schematic diagram of a synchronisation circuit 40 used to synchronise the frequency of the frequency/pulse width control circuit 14 with the frequency of the switching power supply circuit 12 as shown in Figure 1. The synchronisation circuit 40 includes a diode 42 and a resistor 44 which are connected to an output of the switching power supply circuit 12. A series circuit comprising resistors 46 and 48 is connected between a supply voltage and earth potential. The resistor 44 is connected to the junction of the resistors 46 and 48 and to a clock input CLK of a decade counter 50. A resistive-capacitive circuit comprising a resistor 52 and a capacitor 54 is connected to an eighth count output Y8 of the decade counter 50 and to a clear input CLR of the counter 50. The output Y8 of the decade counter 50 is also connected to the base of a transistor 56 via a resistor 58 which is part of an assembly 18 as shown in Figure 1 and Figure 3. The emitter of the transistor 56 is connected to earth potential. The supply voltage is connected to the collector of the transistor 56 via a resistor 60 and is also connected to the base of a transistor 62 via the resistor 60 and a resistor 64. The supply voltage is connected to the emitter of the transistor 62 and the collector of the transistor 62 is connected via a resistor 68 and a diode 66 to earth potential. A timing control signal developed at the output Y8 of the counter 50 is used to control other parts of the vortex shedding flowmeter circuitry, being supplied thereto via a line 51.

The synchronisation circuit 40 uses a downcounter technique to achieve frequency synchronisation, which results in the frequency of the frequency/pulse width control circuit 14 being an exact and fixed division ratio of the frequency of the switching power supply circuit 12. The foregoing is accomplished by utilising a signal provided by the switching power supply circuit 12 and conditioning same via the diode 42 and resistors 44, 46 and 48. The eighth count output Y8 of the decade counter 50 is the output of the synchronisation circuit 40 and is applied to a time delay circuit comprising the resistor 52 and capacitor 54 to clear the counter, thus establishing pulse width and frequency. A buffer stage comprising the resistors 58, 60 and the transistor 56 is provided in order to drive the output circuit.

## Claims

1. Apparatus for synchronising a frequency of a first circuit (14) with a frequency of a second circuit (12), the first circuit (14) having a lower frequency than the frequency of the second circuit (12), the apparatus (16) comprising:
differentiating means (18, 20) for differentiating a signal representative of the frequency of the second circuit (12) to produce a differentiated signal;
coupling means (22) for coupling the differentiated signal to the first circuit (14); and
means (30) responsive to the differentiated signal to cause the first circuit (14) to actuate in synchronisation with the second circuit (12).

2. Apparatus according to claim 1, wherein the differentiating means (18, 20) comprises resistive and capacitive means.

3. Apparatus according to claim 1 or claim 2, wherein the coupling means (22) comprises capacitive means.

4. Apparatus according to claim 1, claim 2 or claim 3, wherein the means (30) responsive to the differentiated signal comprises timing means (30) associated with the first circuit (14), the timing means (30) being operative to produce an output signal having the differentiated signal superimposed thereon.

5. Apparatus for synchronising a frequency of a first circuit (14) with a frequency of a second circuit (12), the first circuit (14) having a lower frequency than the frequency of the second circuit (12), the apparatus (40) comprising:
means (42, 44, 46, 48) for producing a signal having a frequency representative of the frequency of the second circuit (12);
counting means (50) for counting discontinuities within said signal, the counting means (50) being operative to produce an output signal having a frequency that is a division ratio of the frequency of the second circuit (12); and
means (58, 60, 56) responsive to the output signal produced by the counting means (50) to cause the first circuit (14) to actuate in synchronisation with the second circuit (12).

6. Apparatus according to claim 5, including resetting means (52, 54) for resetting the counter means (50), the resetting means (52, 54) being actuatable after a predetermined number of counts by the counter means (50).

7. Apparatus according to claim 6, wherein the resetting means (52, 54) comprises resistive and capacitive means.

# FIG. 1

# FIG. 2

SWITCHER
POWER
SUPPLY
FREQUENCY

18

22

16

20

$V_{SUPPLY}$

24

26

28

555 TYPE TIMER
CIRCUIT

DISCHG.

THRESHOLD

30

14

EP 0 416 877 A2

# FIG. 3

EP 0 416 877 A2